# EUROPÄISCHE PATENTSCHRIFT

(11) **EP 1 658 643 B1**
(45) Veröffentlichungstag und Bekanntmachung des Hinweises auf die Patenterteilung: **14.11.2018**
(21) Anmeldenummer: 04762553.8
(22) Anmeldetag: 30.07.2004
(51) Int. Cl.: H01L 33/02, H01L 33/40

(54) **STRAHLUNGEMITTIERENDES HALBLEITERBAUELEMENT**
RADIATION EMITTING SEMI-CONDUCTOR ELEMENT
DISPOSITIF A SEMI-CONDUCTEUR EMETTEUR DE RAYONNEMENT

(30) Priorität: 29.08.2003 DE 10339983; 07.10.2003 DE 10346605
(43) Veröffentlichungstag der Anmeldung: 24.05.2006
(73) Patentinhaber: OSRAM Opto Semiconductors GmbH, 93055 Regensburg (DE)
(72) Erfinder: STEIN, Wilhelm, 88131 Lindau (DE); WINDISCH, Reiner, 93186 Pettendorf (DE); WIRTH, Ralph, 93186 Pettendorf-Adlersberg (DE); PIETZONKA, Ines, 93049 Regensburg (DE)
(74) Vertreter: Epping - Hermann - Fischer
(86) Internationale Anmeldenummer: PCT/DE2004/001708
(87) Internationale Veröffentlichungsnummer: WO 2005/024961

(56) Entgegenhaltungen:
- WO-A1-02/061855
- WO-A2-01/41225
- US-A- 5 861 636
- US-A- 5 889 295
- US-A1- 2002 137 244
- US-B1- 6 420 732

## Beschreibung

Die Erfindung betrifft ein strahlungemittierendes Halbleiterbauelement mit einem Halbleiterkörper, der eine erste Hauptfläche, eine zweite Hauptfläche und eine Halbleiterschichtenfolge mit einer elektromagnetische Strahlung erzeugenden aktiven Zone umfasst, wobei die Halbleiterschichtenfolge zwischen der ersten und der zweiten Hauptfläche angeordnet ist. Weiterhin betrifft die Erfindung ein Verfahren zur Herstellung eines solchen strahlungemittierenden Halbleiterbauelements.

Der interne Umwandlungswirkungsgrad von elektrischer Energie in Strahlungsenergie ist bei strahlungemittierenden Halbleiterbauelementen meist deutlich höher als der Gesamtwirkungsgrad. Dafür ist im wesentlichen der geringe Auskoppelwirkungsgrad der in der aktiven Zone erzeugten Strahlung aus dem Halbleiterbauelement verantwortlich. Dies hat verschiedene Ursachen. Häufig ist eine großflächige Stromeinbringung in die Halbleiterschichtenfolge erwünscht, was zum Beispiel mittels großflächiger metallischer Kontaktstrukturen möglich ist. Derartige Kontaktstrukturen sind jedoch meist für die erzeugte Strahlung nicht durchlässig und führen zu einer hohen Absorption der erzeugten Strahlung.

Auch bei kleinflächigen, den Halbleiterkörper nicht vollständig bedeckenden, Kontaktstrukuren gibt es Wege, den Strom großflächig einzubringen. Hierzu kann das strahlungemittierende Halbleiterbauelement beispielsweise sogenannte Stromaufweitungsschichten umfassen, die für eine homogene Stromeinbringung in die aktive Zone sorgen. Dies kann einerseits durch in der Halbleiterschichtenfolge angeordnete Schichten aus dotiertem Halbleitermaterial erreicht werden. Derartige Schichten müssen allerdings relativ dick sein, um eine homogene Stromeinbringung in die aktive Zone gewährleisten zu können. Je dicker aber die Halbleiterschicht ist, desto länger ist die für die Herstellung der Schichtenfolge benötigte Zeit. Ferner steigt mit der Schichtdicke die Absorption freier Ladungsträger und/oder der erzeugten Strahlung in diesen Schichten, was zu einem geringen Gesamtwirkungsgrad führt. Weiterhin ist aus JP 2000-353820 ein Bauelement bekannt, das eine für die erzeugte Strahlung durchlässige Stromaufweitungsschicht besitzt. Diese enthält ZnO, welches zur Materialklasse der TCOs (Transparent Conducting Oxides) gehört. Neben ZnO wird aus dieser Klasse auch ITO (Indium Tin Oxide) häufig zur Stromaufweitung benutzt. US 5 889 295 offenbart ein weiteres lichtemittierendes Bauelement mit einer Stromaufweitungsschicht aus ZnO.

Der Auskoppelwirkungsgrad wird ferner durch die Totalreflexion von in der aktiven Zone erzeugter Strahlung an Grenzflächen begrenzt, was in den unterschiedlichen Brechungsindizes des Halbleitermaterials und des Umgebungsmaterials begründet ist. Die Totalreflexion kann durch eine geeignete Strukturierung der Grenzflächen gestört werden. Daraus resultiert ein höherer Auskoppelwirkungsgrad.

Auch die Absorption der Strahlung in einem Substrat oder einem Träger, auf dem die Halbleiterschichtenfolge aufgewachsen oder das strahlungemittierende Halbleiterbauelement befestigt ist, stellt eine der Ursachen für einen geringen Auskoppelwirkungsgrad dar.

Aufgabe der vorliegenden Erfindung ist es, ein strahlungemittierendes Halbleiterbauelement der eingangs genannten Art mit einem erhöhten Gesamtwirkungsgrad zu entwickeln. Weiterhin soll ein Verfahren zur Herstellung strahlungemittierender Halbleiterbauelemente mit erhöhtem Gesamtwirkungsgrad angegeben werden.

Diese Aufgabe wird durch ein strahlungemittierendes Halbleiterbauelement mit den Merkmalen des Anspruchs 1 beziehungsweise ein Verfahren zur Herstellung strahlungemittierender Halbleiterbauelemente gemäß Anspruch 33 gelöst. Vorteilhafte Weiterbildungen der Erfindung sind Gegenstand der abhängigen Ansprüche.

Ein strahlungemittierendes Halbleiterbauelement gemäß der vorliegenden Erfindung weist einen Halbleiterkörper auf, umfassend eine erste Hauptfläche, eine zweite Hauptfläche und eine Halbleiterschichtenfolge mit einer elektromagnetische Strahlung erzeugenden aktiven Zone, wobei die Halbleiterschichtenfolge zwischen der ersten und der zweiten Hauptfläche angeordnet ist, eine erste Stromaufweitungsschicht auf der ersten Hauptfläche angeordnet und mit der Halbleiterschichtenfolge elektrisch leitend verbunden ist sowie eine zweite Stromaufweitungsschicht auf der zweiten Hauptfläche angeordnet und mit der Halbleiterschichtenfolge elektrisch leitend verbunden ist.

Die Stromaufweitungsschichten enthalten elektrisch leitfähige Materialien, welche für die erzeugte Strahlung durchlässig sind. Beide Stromaufweitungsschichten enthalten strahlungsdurchlässige leitfähige Oxide, bevorzugt Metalloxide, wie beispielsweise ZnO, InO und/oder SnO oder auch Oxide mit zwei oder mehr metallischen Bestandteilen, wie ITO. Stromaufweitungsschichten aus diesen Materialien sind besonders geeignet, da sie unter anderem einen geringen Schichtwiderstand besitzen, der einen homogenen Stromeintrag in die Halbleiterschichtenfolge gewährleistet. Weiterhin weisen sie große Wellenlängenbereiche hoher Transmission auf. Die Widerstände liegen vorteilhafterweise unter 200 Ω/□, wobei Werte von weniger als 30 Ω/□ besonders bevorzugt sind. Die Einheit Ω/□ (Ohm per Square) entspricht dabei dem Widerstand einer quadratischen Fläche der Schicht.

Die Dicken der Stromaufweitungsschichten sind bei der Erfindung so gewählt, dass ein homogener Stromeintrag in die Halbleiterschichtenfolge bewirkt wird. Dies wird mit Schichtdicken von 10nm bis zu 1000nm, besonders bevorzugt von 200nm bis 800nm, erreicht.

Mit Vorteil enthält mindestens eine der strahlungsdurchlässigen leitfähigen Stromaufweitungsschichten Al, Ga, In, Ce, Sb und/oder F als Dotierstoff(e), um den Schichtwiderstand der Stromaufweitungsschichten zu verringern. Beispielsweise enthält die erste Stromaufweitungsschicht ZnO und ist mit Al dotiert, und die zweite Stromaufweitungsschicht SnO und ist mit Sb dotiert.

Die Stromaufweitungsschichten können beispielsweise durch Sputtern, insbesondere DC-Sputtern, aufgebracht werden, wobei die Prozessparameter so gewählt sind, dass ein elektrischer Kontakt zwischen der Stromaufweitungsschicht und den angrenzenden Halbleiterschichten gebildet wird, der einen homogenen Stromeintrag in die Halbleiterschichtenfolge und somit in die aktive Zone ermöglicht. Der elektrische Kontakt zwischen diesen Schichten kann zum Beispiel durch Sintern oder geeignete Vorreinigung der entsprechenden Oberflächen der beteiligten Schichten noch verbessert werden. Durch die Gegenwart zweier Stromaufweitungsschichten wird der Strom auf beiden Seiten der Halbleiterschichtenfolge sehr homogen eingebracht und es entsteht eine aktive Zone hoher Güte, die sich durch eine gleichmäßig verteilte Strahlungserzeugung und eine vorteilhaft geringe Absorption auszeichnet.

Auf mindestens einer der Stromaufweitungsschichten ist eine Spiegelschicht angeordnet, die bevorzugt elektrisch leitend ist und weitergehend eine hohe Reflektivität für die in der aktive Zone erzeugte Strahlung aufweist.

Durch die Spiegelschicht werden Absorptionsverluste in eventuell unter dieser angeordneten Schichten, wie zum Beispiel einem Substrat oder einem Träger, verringert und sie bildet zusammen mit der Stromaufweitungsschicht einen hocheffizienten elektrischen Spiegelkontakt zur Kontaktierung des Halbleiterbauelements. Die Spiegelschicht enthält vorzugsweise ein Metall, vorteilhafterweise Au, Ag, Al, Pt und/oder eine Legierung mit mindestens einem dieser Materialien. Die Spiegelschicht ist auf der der Halbleiterschichtenfolge abgewandten Seite der Stromaufweitungsschicht auf der ersten Hauptfläche angeordnet. Die Spiegelschicht kann beispielsweise durch Aufdampfen oder Sputtern aufgebracht werden.

In einer weiteren bevorzugten Ausgestaltung der Erfindung weist mindestens eine Hauptfläche der Halbleiterschichtenfolge eine Mikrostruktur auf, die vor dem Aufbringen der Stromaufweitungsschicht in oder auf die entsprechende Hauptfläche ein- beziehungsweise aufgebracht wurde. Die Mikrostruktur ist dabei so geartet, dass die strukturierte Fläche im Gegensatz zur unstrukturierten einen höheren Auskoppelwirkungsgrad aufgrund einer gestörten Totalreflexion von auf diese Fläche einfallenden Strahlen, die in der aktiven Zone erzeugt wurden, aufweist. Damit wird die Strahlungsauskopplung und somit der Gesamtwirkungsgrad des strahlungemittierenden Halbleiterbauelementes erhöht. Solche Mikrostrukturen können beispielsweise durch Aufrauhverfahren wie ein Ätz- oder Schleifverfahren erzeugt werden. Weiterhin kann eine solche Mikrostruktur dadurch erzeugt werden, dass ein metallisches Maskenmaterial auf die zu strukturierende Fläche aufgebracht wird, dessen Benetzungseigenschaften so beschaffen sind, dass sich auf der Oberfläche kleine vorzugsweise zumindest teilweise vernetzte metallische Inseln bilden. Diese Inselstruktur kann mittels eines Trockenätzverfahrens in die zu strukturierende Fläche übertragen werden, wonach das Maskenmaterial durch geeignete Verfahren entfernt werden kann. Mit Vorzug weist die Hauptfläche auf der der Spiegelschicht abgewandten Seite der Halbleiterschichtenfolge eine Mikrostruktur auf.

Bei einer vorteilhaften Weiterbildung der Erfindung besitzt die Halbleiterschichtenfolge mindestens eine n- und eine p-leitende Schicht. Die Dicken der n- und/oder p-leitenden Schichten liegen typischerweise zwischen einer Monolage und 1000 nm. Bevorzugt ist die Dicke mindestens einer oder beider dieser Schichten kleiner als 400 nm, und liegt besonders bevorzugt zwischen 150 nm und 350 nm. Bei herkömmlichen Bauelementen dienen die um die aktive Zone angeordneten n- und/oder p-leitenden Schichten oftmals auch der Stromaufweitung und besitzen daher eine relativ große Dicke.

Bei der Erfindung hingegen erfolgt die Stromaufweitung in den außerhalb des Halbleiterkörpers angeordneten Stromaufweitungsschichten. Deshalb können die Schichten der Halbleiterschichtenfolge vergleichsweise dünn ausgeführt sein.

Eine Halbleiterschichtenfolge mit derartig vorteilhaft geringen Schichtdicken wirkt sich in vielerlei Hinsicht positiv auf die Funktionsweise des strahlungemittierenden Halbleiterbauelementes aus. So werden beispielsweise die Absorption freier Ladungsträger, die Absorption der erzeugten Strahlung und die zur Herstellung derartiger Bauelemente benötigten E-pitaxiezeiten wesentlich verringert, wodurch der Auskoppelwirkungsgrad des strahlungemittierenden Halbleiterbauelements erhöht, die Herstellungszeiten der Halbleiterschichtenfolge verkürzt und deren Herstellungskosten verringert werden.

Die Halbleiterschichtenfolge mit den n- und p-leitenden Schichten und einer Strahlung erzeugenden aktiven Zone wird durch epitaktisches Aufwachsen auf einem Substrat, beispielsweise einem GaAs Substrat, hergestellt. Die Stromaufweitungsschichten werden vorzugsweise nach der Epitaxiephase zum Beispiel durch Sputtern aufgebracht.

Bevorzugt enthält die Halbleiterschichtenfolge einen III-V-Halbleiter, wie beispielsweise InₓGa_{y}Al_{1-x-y}P, mit 0≤x≤1, 0≤x≤1 und x+y≤1, InₓGa_{y}Al_{1-x-y}N, mit 0≤x≤1, 0≤y≤1 und x+y≤1, oder InₓGa_{y}Al_{1-x-y}As, mit 0≤x≤1, 0≤y≤1 und x+y≤1.

Mit besonderem Vorteil enthält die Stromaufweitungsschicht, die auf der p-leitenden Seite der Halbleiterschichtenfolge angeordnet ist, ZnO, bevorzugt mit Al dotiert, und jene, die auf der n-leitenden Seite angeordnet ist SnO, bevorzugt mit Sb dotiert. Sn beispielsweise kann bei III-V-Halbleitern im n-leitenden Bereich zugleich als Dotierstoff eingesetzt werden. Eine Diffusion von Sn-Atomen aus einer SnO enthaltenden Stromaufweitungsschicht in eine angrenzende n-leitende Schicht erhöht daher die Majoritätsladungsträgerkonzentration in der n-leitenden Schicht. Insbesondere gilt dies an der Grenzfläche der beiden Schichten. Daher wird der leitende Kontakt zwischen solchen Schichten und damit die Stromeinbringung in die aktive Zone verbessert. Entsprechendes gilt für Zn als Akzeptor im Bezug auf p-leitende Schichten.

Die erste Stromaufweitungsschicht ist von der zweiten Stromaufweitungsschicht verschieden, so dass das Material der jeweiligen Stromaufweitungsschicht je nach den Kontakteigenschaften vorteilhaft an das seitens des Halbleiterkörpers angrenzende Material angepasst werden kann.

In einer vorteilhaften Weiterbildung der Erfindung bildet die erste und/oder zweite Stromaufweitungsschicht im Betrieb des strahlungemittierenden Halbleiterbauelements einen elektrischen Kontakt mit einer ohmschen Charakteristik (ohmscher Kontakt) zum Halbleiterkörper aus. Der Kontakt weist hierbei vorzugsweise zumindest annähernd eine lineare Strom-Spannungs-Kennlinie im Bereich der im Betrieb des strahlungemittierenden Halbleiterbauelements anfallenden Strom- bzw. Spannungswerte auf.

Bevorzugt bildet die auf der p-leitenden Seite des Halbleiterkörpers angeordnete Stromaufweitungsschicht zum Halbleiterkörper einen ohmschen Kontakt aus. Besonders bevorzugt grenzt hierzu seitens des Halbleiterkörpers eine p-leitende AlGaAs-haltige Schicht an eine ZnO-haltige Stromaufweitungsschicht an. Eine derartige Kombination hat sich zur Ausbildung eines ohmschen Kontakts als besonders vorteilhaft erwiesen.

Gemäss der Erfindung ist die Halbleiterschichtenfolge epitaktisch auf einem Substrat aufgewachsen, das nach dem Epitaxieprozess durch geeignete Maßnahmen, zum Beispiel eine mechanische Belastung oder einen Ätzvorgang, entfernt wurde. Die Halbleiterschichtenfolge ist über die erste Hauptfläche mit einem Träger, zum Beispiel aus GaAs, verbunden. Die Verbindung ist vorzugsweise elektrisch leitend und kann mittels einer Lotmetallisierung erfolgen. Zwischen dem Träger und der ersten Hauptfläche ist eine Stromaufweitungsschicht angeordnet, auf deren der Halbleiterschichtenfolge abgewandten Seite sich eine Spiegelschicht befindet. Die zwei folgenden vorteilhaften Weiterbildungen basieren hierauf.

In einer ersten vorteilhaften Weiterbildung der obigen Ausgestaltung weist die weiter vom Träger entfernte zweite Hauptfläche eine Mikrostruktur auf, die die Totalreflexion von auf diese Fläche einfallenden Strahlen stört. Auf dieser Hauptfläche ist eine weitere Stromaufweitungsschicht angeordnet, der eine Kontaktfläche zur elektrischen Kontaktierung des Halbleiterbauelements nachgeordnet ist. Die Kontaktfläche hat vorzugsweise eine geringere laterale Ausdehnung als die Halbleiterschichtenfolge und/oder die Stromaufweitungsschichten. Des weiteren kann sie auch auf der der Halbleiterschichtenfolge zugewandten Seite eine die in der aktiven Zone erzeugte Strahlung reflektierende Schicht besitzen oder selbst reflektierend sein. Mittels der Stromaufweitungsschichten wird der über die Kontaktfläche injizierte Strom lateral homogen verteilt und großflächig in die aktive Zone eingebracht. Dadurch wird eine nachteilig vermehrte Strahlungserzeugung in dem unter der absorbierenden Kontaktfläche liegenden Bereich der aktiven Zone vermieden. In der Folge wird so die Absorption der erzeugten Strahlung in der Kontaktfläche durch die reflektierende Schicht vermindert und damit der Auskoppelwirkungsgrad des Bauelements erhöht.

In einer zweiten vorteilhaften Weiterbildung der obigen Ausgestaltung weist die weiter vom Träger entfernte zweite Hauptfläche eine Mikrostruktur auf. Dieser nachgeordnet ist eine für die erzeugte Strahlung durchlässige Mantelschicht oder eine Mantelschichtenfolge, die aus mehreren Schichten besteht und mit der zweiten Stromaufweitungsschicht versehen ist. Diese Stromaufweitungsschicht besitzt hierbei mindestens eine Ausnehmung oder ein Fenster, dergestalt dass die Mantelschichtenfolge im Bereich der Ausnehmung oder des Fensters nicht von der Stromaufweitungsschicht bedeckt ist. Die Ausnehmung wird von einer Kontaktfläche zur elektrischen Kontaktierung zumindest teilweise ausgefüllt, die sich mit der Mantelschichtenfolge und der Stromaufweitungsschicht in Kontakt befindet.

Die Kontaktfläche ist vorteilhafterweise metallisch und hat bezüglich des Übergangs zur Mantelschichtenfolge im Falle einer in Vorwärtsrichtung anliegenden Spannung eine so hohe Potentialbarriere (z.B. eine Schottky-Barriere), dass nahezu der ganze Strom von der Kontaktfläche in die lateral angrenzende Stromaufweitungsschicht und von dort über die Mantelschicht in die aktive Zone eintritt. Dadurch gelangt nur ein geringer Stromanteil in den Bereich der aktiven Zone, der unter der Kontaktfläche liegt, und es wird in diesem Bereich nur eine verglichen mit der restlichen aktiven Zone geringe Strahlung erzeugt. Daher wird die Absorption der erzeugten Strahlung in der Kontaktfläche verringert. Weitergehend kann eine Mikrostruktur oder eine Mantelschicht(enfolge) der oben genannten Art auch auf der dem Träger zugewandten Seite der Halbleiterschichtenfolge ausgebildet sein.

Ein erfindungsgemäßes Herstellungsverfahren für ein strahlungemittierendes Halbleiterbauelement mit einem Halbleiterkörper, der eine erste Hauptfläche, eine zweite Hauptfläche und eine Halbleiterschichtenfolge mit einer elektromagnetische Strahlung erzeugenden aktiven Zone umfasst, wobei die Halbleiterschichtenfolge zwischen der ersten und der zweiten Hauptfläche angeordnet ist, weist folgende Schritte auf:
- Aufwachsen der Halbleiterschichtenfolge auf einem Substrat;
- Aufbringen einer strahlungsdurchlässigen Stromaufweitungsschicht auf die erste Hauptfläche;
- Ablösen des Substrats;
- Aufbringen einer strahlungsdurchlässigen Stromaufweitungsschicht auf die zweite Hauptfläche.

Die Aufzählung der Schritte ist hierbei nicht als Festlegung auf eine bestimmte Reihenfolge zu verstehen.

Die Halbleiterschichtenfolge wird epitaktisch aufgewachsen. Das Substrat kann mittels eines geeigneten Verfahrens, wie zum Beispiel eines Ätzprozesses oder mechanischer Belastung, entfernt werden. Die Stromaufweitungsschichten enthalten bevorzugt ein TCO, besonders bevorzugt ZnO und/oder SnO.

Zur Verminderung des Schichtwiderstandes ist es vorteilhaft, mindestens eine Stromaufweitungsschicht mit Al, Ga, In, Ce, Sb und/oder F zu dotieren.

Weitere Ausgestaltungen des dargestellten Verfahrens ergeben sich durch die nachfolgend beschriebenen Schritte, die an geeigneter Stelle in obiges Verfahren eingegliedert werden können. Insbesondere können dabei auch manche Schritte auf beiden Seiten der Halbleiterschichtenfolge durchgeführt werden.

Im erfindungsgemässen Verfahren wird auf die Stromaufweitungsschicht auf der ersten Hauptfläche eine Spiegelschicht, die bevorzugt Au, Ag, Al, Pt und/oder eine Legierung mit mindestens einem dieser Materialien enthält, aufgebracht.

Der Halbleiterkörper wird nachfolgend über die Spiegelschicht auf einem Träger befestigt, wobei die Befestigung bevorzugt mittels einer Lotmetallisierung erfolgt. Das Substrat wird mit Vorzug nach der Befestigung des Halbleiterkörpers auf dem Träger abgelöst. Der Träger kann somit vom Substrat verschieden sein.

Weiterhin kann mindestens eine Hauptfläche mit einer Mikrostruktur zur Störung der Totalreflexion von der in der aktiven Zone erzeugten Strahlung an dieser Hauptfläche versehen werden.

Ferner wird in einer weiteren bevorzugten Ausgestaltung des Verfahrens eine Mantelschicht oder eine Mantelschichtenfolge, die zwischen einer Stromaufweitungsschicht und der Halbleiterschichtenfolge angeordnet ist, aufgebracht. In die der Mantelschicht nächstliegende Stromaufweitungsschicht kann eine Ausnehmung eingebracht werden, die mit Vorzug zumindest teilweise von einer Kontaktfläche zur elektrischen Kontaktierung des strahlungemittierenden Halbleiterbauelements ausgefüllt wird. Die Ausnehmung wird bevorzugt so gebildet, dass die Stromaufweitungsschicht in dem Bereich der Ausnehmung vollständig entfernt ist.

Ist keine Ausnehmung vorgesehen, kann eine Kontaktfläche auf die weiter vom Träger entfernte Stromaufweitungsschicht aufgebracht werden.

Besonders bevorzugt wird das dargestellte Verfahren zur Herstellung der im Anspruch 1 und den abhängigen Ansprüchen beschriebenen Halbleiterbauelemente benutzt.

Weitere Merkmale, Vorteile und Zweckmäßigkeiten der Erfindung ergeben sich aus den Beschreibungen der folgenden Ausführungsbeispiele in Verbindung mit den folgenden Figuren.
- Figur 1: zeigt eine schematische Schnittansicht eines ersten Ausführungsbeispiels eines erfindungsgemäßen strahlungemittierenden Halbleiterbauelements;
- Figur 2: zeigt eine schematische Schnittansicht eines zweiten Ausführungsbeispiels eines erfindungsgemäßen strahlungemittierenden Halbleiterbauelements;
- Figur 3: zeigt eine schematische Schnittansicht eines dritten Ausführungsbeispiels eines erfindungsgemäßen strahlungemittierenden Halbleiterbauelements;
- Figur 4: zeigt in den Figuren 4A bis 4D eine schematische Darstellung eines Ausführungsbeispiels eines erfindungsgemäßen Verfahrens zur Herstellung eines strahlungemittierenden Halbleiterbauelements, anhand von vier Zwischenschritten.

Gleichartige und gleich wirkende Elemente besitzen in den Figuren gleiche Bezugszeichen.

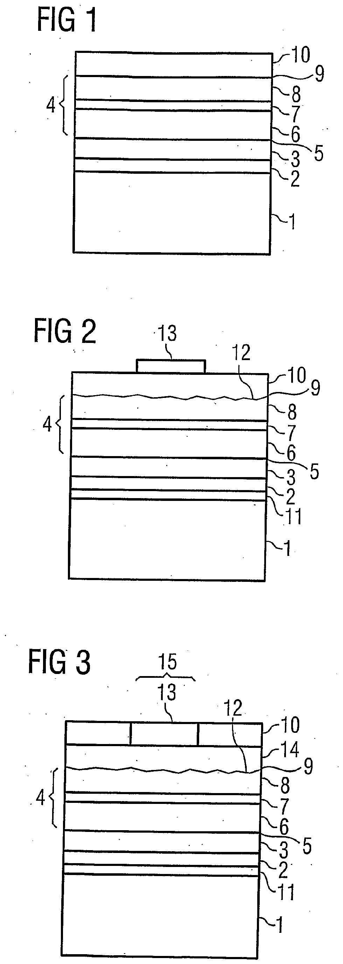

In Figur 1 ist eine schematische Schnittansicht eines ersten Ausführungsbeispiels eines erfindungsgemäßen strahlungemittierenden Halbleiterbauelements dargestellt. Auf einem GaAs-Träger 1 ist eine Spiegelschicht 2 aus Au und auf dieser eine erste Stromaufweitungsschicht 3 angeordnet, die ZnO und Al, zum Beispiel in der Zusammensetzung Al_{0,02}Zn_{0,98}O, enthält. Diesen Schichten nachgeordnet ist ein Halbleiterkörper mit einer Halbleiterschichtenfolge 4, welche InₓGa_{y}Al_{1-x-y}P mit 0≤x≤1, 0≤y≤1 und x+y≤1 enthält. Die Halbleiterschichtenfolge 4 weist eine erste Hauptfläche 5, eine oder mehreren Halbleiterschichten eines ersten Leitungstyps 6, eine Strahlung erzeugenden aktiven Zone 7, eine oder mehreren Halbleiterschichten eines zweiten Leitungstyps 8 und eine zweite Hauptfläche 9 auf. Auf der zweiten Hauptfläche 9 ist eine zweite Stromaufweitungsschicht 10 angeordnet, die SnO und Sb zum Beispiel in der Zusammensetzung Sb_{0,2}Sn_{0,98}O enthält. Die Schichten 6 und 8 sind p- beziehungsweise n-leitend und weisen eine jeweilige Gesamtschichtdicke von beispielsweise 200nm auf.

Die Halbleiterschichtenfolge 4 ist durch Epitaxie auf einem Aufwachssubstrat aus GaAs hergestellt, das nach dem Aufbringen der Spiegelschicht 2 abgelöst wurde. Die Kombination aus der Spiegelschicht 2 und der Stromaufweitungsschicht 3 dient als hocheffizienter Spiegelkontakt zur homogenen Stromeinbringung in die Halbleiterschichtenfolge 4. Dadurch wird die Absorption der Strahlung in dem Träger 1 verringert und in Kombination mit der zweiten Stromaufweitungsschicht 10 auf der zweiten Hauptfläche 9 ein sehr homogener Stromeintrag über beide Hauptflächen 5 und 9 in die Halbleiterschichtenfolge 4 und besonders in die aktive Zone 7 gewährleistet. Es entsteht somit eine aktive Zone 7 hoher Güte, in der lateral gleichmäßig Strahlung erzeugt wird.

Die geringen Schichtdicken der Halbleiterschichten 6 und 8 erlauben einen kürzeren Herstellungsprozess des Halbleiterkörpers und verringern die Absorption freier Ladungsträger sowie der erzeugten Strahlung in diesen Schichten. Die Schichtdicken sind nach unten dadurch begrenzt, dass sie eine Diffusion von Fremdatomen aus den angrenzenden Stromaufweitungsschichten in die aktive Zone verhindern sollen, ihre Dicke groß genug für eine mögliche Ein- oder Aufbringung einer Mikrostruktur ist und/oder die Ladungsträger möglichst lange in der aktiven Zone verweilen.

Die Kombination aus zwei Stromaufweitungsschichten 3 und 10 bewirkt eine Erhöhung des Gesamtwirkungsgrades, der durch die Spiegelschicht 2 und die dünnen Schichten verschiedener Leitungstypen 6 und 8 noch weiter gesteigert wird.

Mit Vorzug grenzt seitens der Halbleiterschicht(en) 6 eine p-leitende AlGaAs-Schicht an die Stromaufweitungsschicht 3. Die AlGaAs-Schicht ist mit Vorteil im Halbleiterkörper bzw. der Halbleiterschichtenfolge integriert. Die Ausbildung eines im wesentlichen ohmschen Kontaktes zwischen Stromaufweitungsschicht und Halbleiterkörper wird so erleichtert.

Die elektrische Kontaktierung des Bauelements kann über eine seitens der zweiten Hauptfläche 9 bzw. der zweiten Stromaufweitungsschicht 10 angeordnete Kontaktfläche und eine auf der dem Halbleiterkörper gegenüberliegenden Seite des Trägers 1 angeordnete Gegenkontaktfläche erfolgen. Dies ist in Figur 1 nicht dargestellt.

Figur 2 zeigt eine schematische Schnittansicht eines zweiten Ausführungsbeispiels eines erfindungsgemäßen strahlungemittierenden Halbleiterbauelements, das im wesentlichen mit dem in Figur 1 skizzierten Aufbau übereinstimmt. Im Unterschied dazu ist die Spiegelschicht 2 über eine Lotmetallisierung 11 auf dem Träger befestigt und so mit diesem elektrisch leitend verbunden. Weiterhin ist die zweite Hauptfläche 9 mit einer Mikrostruktur 12 versehen, die beispielsweise mittels des oben erwähnten Verfahrens mit einer metallischen Maskenschicht hergestellt wurde. Dies stört die Totalreflexion und erhöht damit den Auskoppelwirkungsgrad.

Ferner ist auf der zweiten Stromaufweitungsschicht 10 eine Kontaktfläche 13 zur elektrischen Kontaktierung angeordnet, die auf ihrer der Halbleiterschichtenfolge 4 zugewandten Seite bezüglich der in der aktiven Zone 7 reflektierend sein kann, was nicht explizit gezeigt ist. Die Kontaktfläche 13 hat eine geringere laterale Ausdehnung als die Stromaufweitungsschichten 3, 10 und/oder die Halbleiterschichtenfolge 4. Die Absorption der erzeugten Strahlung in der Kontaktfläche 13 wird so reduziert, da eine vermehrte Strahlungserzeugung in dem Bereich der aktiven Zone 7, der von der absorbierenden Kontaktfläche 13 abgeschattet wird, vermieden wird. Eine Verspiegelung der Unterseite der Kontaktfläche 13 trägt weiter zur Verminderung der Absorption in der Kontaktfläche 13 bei. Insgesamt wird also der Auskoppelwirkungsgrad im Gegensatz zu dem in Figur 1 dargestellten Ausführungsbeispiel weiter erhöht.

In Figur 3 ist eine schematische Schnittansicht eines dritten Ausführungsbeispiels eines erfindungsgemäßen strahlungemittierenden Halbleiterbauelements dargestellt. Der prinzipielle Aufbau entspricht wieder dem in Figur 2 gezeigten. Im Unterschied hierzu ist zwischen der Stromaufweitungsschicht 10 und der zweiten Hauptfläche 9 eine Mantelschicht 14 angeordnet. Zudem erfolgt die elektrische Kontaktierung durch eine Kontaktfläche 13, die in einer Ausnehmung 15 der Stromaufweitungsschicht 10 angeordnet ist und mit der Stromaufweitungsschicht 10 und der elektrisch leitenden Mantelschicht 14 in unmittelbarem Kontakt steht. Die elektrischen Kontakte zwischen diesen Schichten sind so hergestellt, dass der Strom von der Kontaktfläche 13 aus hauptsächlich über die Stromaufweitungs- 10 und nachfolgend die Mantelschicht 14 in die Halbleiterschichtenfolge 4 und die aktive Zone 7 gelangt. Der Kontakt zwischen der Mantelschicht 14 und der Kontaktfläche 13 weist hierbei eine ausreichend hohe Potentialbarriere (zum Beispiel eine Schottky-Barriere) auf, die verhindert, dass der Strom direkt von der Kontaktfläche 13 über die Mantelschicht 14 in die Halbleiterschichtenfolge 4 gelangt oder einen Stromfluß über diesen Pfad zumindest reduziert.

Die Mantelschicht 14 ist vorzugsweise für die erzeugte Strahlung durchlässig und enthält beispielsweise AlₓGa₁₋ₓAs_{y}P_{1-x-y} mit 0≤x≤1 und 0≤y≤1. Eine derartige Kontaktierung bewirkt, dass verglichen mit dem in Figur 2 dargestellten Ausführungsbeispiel ein geringerer Stromanteil in den Bereich der aktiven Zone 7 injiziert wird, der von der Kontaktfläche 13 abgeschattet wird. Damit wird in diesem Bereich eine vergleichsweise geringe Strahlungsleistung erzeugt, so dass in der Kontaktfläche 13 nur eine entsprechend geringe Strahlungsmenge absorbiert wird. Verglichen mit dem in Figur 2 dargestellten Gegenstand wird hiermit der Auskoppelwirkungsgrad weiter erhöht.

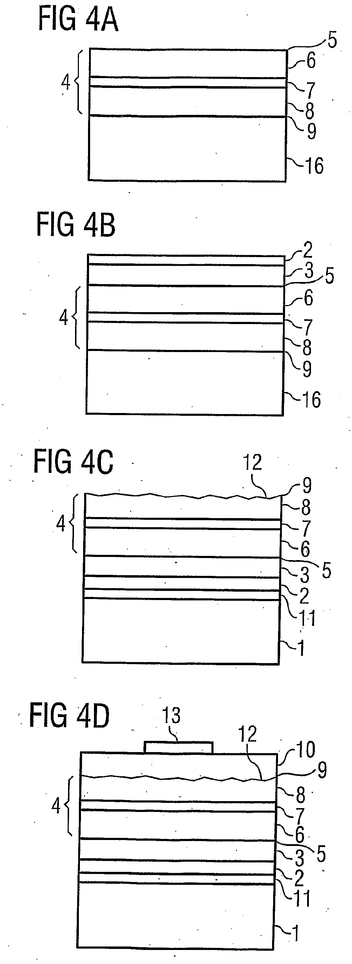

In den Figuren 4a bis 4d ist ein eine schematische Darstellung eines Ausführungsbeispiels eines erfindungsgemäßen Verfahrens zur Herstellung eines strahlungemittierenden Halbleiterbauelements mit hohem Gesamtwirkungsgrad anhand von vier Zwischenschritten gezeigt.

In Figur 4a ist eine Halbleiterschichtenfolge 4 dargestellt, die epitaktisch auf einem Substrat 16, beispielsweise aus GaAs, aufgewachsen wurde. Die Halbleiterschichtenfolge 4 bildet einen Halbleiterkörper, der eine erste Hauptfläche 5, eine Schicht eines ersten Leitungstyps 6 (z.B. p-leitend), eine elektromagnetische Strahlung erzeugende aktive Zone 7, eine Schicht eines zweiten Leitungstyps 8 (z.B. n-leitend) und eine zweite Hauptfläche 9 umfasst. Die Dicken der Schichten 6 und 8 betragen jeweils 200nm. Die Halbleiterschichtenfolge 4 basiert beispielsweise auf InₓGa_{y}Al_{1-x-y}P mit 0≤x≤1, 0≤y≤1 und x+y≤1.

In Figur 4b wird auf die erste Hauptfläche 5 eine Stromaufweitungsschicht 3 aus Al_{0,02}Zn_{0,98}O aufgesputtert. Diese wird durch Aufdampfen oder Sputtern mit einer Spiegelschicht 2 aus Au versehen. Nachfolgend wird die Spiegelschicht 2 wie in Figur 4c gezeigt mittels einer Lotmetallisierung 11 auf einem Träger 1, vorzugsweise aus GaAs, befestigt und das Substrat 16 entfernt, wobei die Spiegelschicht 2 mit dem Träger 1 elektrisch leitend verbunden ist. Ferner wird in die zweite Hauptfläche 9, die jetzt nicht mehr mit dem Substrat 16 verbunden ist, auf geeignete Weise eine Mikrostruktur 12 auf- oder eingebracht, die die Totalreflexion an dieser Fläche stört. Der Träger 1 ist somit insbesondere vom Substrat 16 verschieden.

Nachfolgend wird auf die Hauptfläche 9 mit der Mikrostruktur 12 eine weitere Stromaufweitungsschicht 10, die Sb_{0,02}Sn_{0,98}O enthält, gesputtert, welche in Figur 4d in einem letzten Verfahrensschritt mit einer Kontaktfläche 13 zur elektrischen Kontaktierung des strahlungemittierenden Halbleiterbauelements versehen wird.

## Patentansprüche

1. Strahlungemittierendes Halbleiterbauelement mit einem Halbleiterkörper, umfassend eine erste Hauptfläche (5), eine zweite Hauptfläche (9) und eine epitaktisch aufgewachsene Halbleiterschichtenfolge (4) mit einer elektromagnetische Strahlung erzeugenden aktiven Zone (7), wobei
- die Halbleiterschichtenfolge (4) den Halbleiterkörper bildet und zwischen der ersten und der zweiten Hauptfläche (5,9) angeordnet ist,
- eine erste Stromaufweitungsschicht (3) außerhalb des Halbleiterkörpers auf der ersten Hauptfläche (5) angeordnet und mit der Halbleiterschichtenfolge (4) elektrisch leitend verbunden ist;
- eine zweite Stromaufweitungsschicht (10) außerhalb des Halbleiterkörpers auf der zweiten Hauptfläche (9) angeordnet und mit der Halbleiterschichtenfolge (4) elektrisch leitend verbunden ist;
- die Halbleiterschichtenfolge über die erste Hauptfläche mit einem Träger (1) verbunden ist;
- zwischen dem Träger und der ersten Hauptfläche die erste Stromaufweitungsschicht und auf der der Halbleiterschichtenfolge abgewandten Seite der ersten Stromaufweitungsschicht eine Spiegelschicht (2) angeordnet sind;
- die erste Stromaufweitungsschicht und die zweite Stromaufweitungsschicht ein für die erzeugte Strahlung durchlässiges Oxid enthalten;
- die erste Stromaufweitungsschicht (3) und die zweite Stromaufweitungsschicht (10) bezüglich des Materials voneinander verschieden sind; und
- die Spiegelschicht ein Metall enthält.

2. Strahlungemittierendes Halbleiterbauelement nach Anspruch 1,
**dadurch gekennzeichnet, dass**
mindestens eine der beiden Hauptflächen (5,9) mit den Stromaufweitungsschichten (3,10) eine Mikrostruktur (12) aufweist.

3. Strahlungemittierendes Halbleiterbauelement nach Anspruch 1 oder 2,
**dadurch gekennzeichnet, dass**
das strahlungsdurchlässige Material ITO und/oder InO enthält.

4. Strahlungemittierendes Halbleiterbauelement nach Anspruch 1 oder 2,
**dadurch gekennzeichnet, dass**
das strahlungsdurchlässige Material ZnO enthält.

5. Strahlungemittierendes Halbleiterbauelement nach Anspruch 1 oder 2,
**dadurch gekennzeichnet, dass**
das strahlungsdurchlässige Material SnO enthält.

6. Strahlungemittierendes Halbleiterbauelement nach einem der Ansprüche 1 bis 5,
**dadurch gekennzeichnet, dass**
mindestens eine der Stromaufweitungsschichten (3,10) Al, Ga, In, Ce, Sb und/oder F enthält.

7. Strahlungemittierendes Halbleiterbauelement nach einem der Ansprüche 1 bis 6,
**dadurch gekennzeichnet,**
**dass** die Spiegelschicht (2) elektrisch leitend ist.

8. Strahlungemittierendes Halbleiterbauelement nach einem der Ansprüche 1 bis 7,
**dadurch gekennzeichnet, dass**
die Spiegelschicht (2) Au, Ag, Al und/oder Pt enthält.

9. Strahlungemittierendes Halbleiterbauelement nach einem der Ansprüche 1 bis 8,
**dadurch gekennzeichnet, dass**
die Hauptfläche (9) auf der der Spiegelschicht (2) abgewandten Seite der Halbleiterschichtenfolge (4) eine Mikrostruktur (12) aufweist.

10. Strahlungemittierendes Halbleiterbauelement nach einem der Ansprüche 1 bis 9,
**dadurch gekennzeichnet, dass**
die Halbleiterschichtenfolge (4) mindestens eine n- und/oder eine p-leitende Schicht (6,8) enthält.

11. Strahlungemittierendes Halbleiterbauelement nach Anspruch 10,
**dadurch gekennzeichnet, dass**
die Dicke der n-leitenden und/oder der p-leitenden Schichten (6,8) im Bereich von einer Monolage bis 1000nm liegt.

12. Strahlungemittierendes Halbleiterbauelement nach Anspruch 11,
**dadurch gekennzeichnet, dass**
die Dicke der n-leitenden und/oder der p-leitenden Schichten (6,8) kleiner als 400nm ist.

13. Strahlungemittierendes Halbleiterbauelement nach Anspruch 11,
**dadurch gekennzeichnet, dass**
die Dicke der n-leitenden und/oder der p-leitenden Schichten (6,8) zwischen 150nm und 350nm liegt.

14. Strahlungemittierendes Halbleiterbauelement nach Anspruch 10 oder 11,
**dadurch gekennzeichnet, dass** die Halbleiterschichtenfolge mindestens eine p-leitende Schicht enthält, und die Stromaufweitungsschicht auf der Seite der p-leitenden Schicht der Halbleiterschichtenfolge ZnO enthält.

15. Strahlungemittierendes Halbleiterbauelement nach Anspruch 14,
**dadurch gekennzeichnet, dass**
die Stromaufweitungsschicht auf der Seite der p-leitenden Schicht der Halbleiterschichtenfolge ZnO und Al enthält.

16. Strahlungemittierendes Halbleiterbauelement nach einem der Ansprüche 10 bis 15,
**dadurch gekennzeichnet, dass** die Halbleiterschichtenfolge mindestens eine n-leitende Schicht enthält, und die Stromaufweitungsschicht auf der Seite der n-leitenden Schicht der Halbleiterschichtenfolge SnO enthält.

17. Strahlungemittierendes Halbleiterbauelement nach Anspruch 16,
**dadurch gekennzeichnet, dass**
die Stromaufweitungsschicht auf der Seite der n-leitenden Schicht der Halbleiterschichtenfolge SnO und Sb enthält.

18. Strahlungemittierendes Halbleiterbauelement nach einem der Ansprüche 1 bis 17,
**dadurch gekennzeichnet, dass**
der Träger (1) GaAs enthält.

19. Strahlungemittierendes Halbleiterbauelement nach einem der Ansprüche 1 bis 18,
**dadurch gekennzeichnet, dass**
das strahlungemittierende Halbleiterbauelement mittels einer Lotmetallisierung (11) auf dem Träger befestigt ist.

20. Strahlungemittierendes Halbleiterbauelement nach Anspruch 19,
**dadurch gekennzeichnet, dass**
die Lotmetallisierung direkt an den Träger (1) angrenzt.

21. Strahlungemittierendes Halbleiterbauelement nach Anspruch 20,
**dadurch gekennzeichnet, dass**
die Lotmetallisierung (11) auf der Spiegelschicht (2) angeordnet ist.

22. Strahlungemittierendes Halbleiterbauelement nach einem der Ansprüche 1 bis 21,
**dadurch gekennzeichnet, dass**
auf einer Stromaufweitungsschicht (10) eine Kontaktfläche (13) zur elektrischen Kontaktierung angeordnet ist.

23. Strahlungemittierendes Halbleiterbauelement nach Anspruch 22,
**dadurch gekennzeichnet, dass**
die Kontaktfläche (13) auf der dem Träger (1) gegenüberliegenden Seite der Halbleiterschichtenfolge (4) angeordnet ist.

24. Strahlungemittierendes Halbleiterbauelement nach Anspruch 22 oder 23,
**dadurch gekennzeichnet, dass** die Kontaktfläche (13) auf der der Halbleiterschichtenfolge (4) zugewandten Seite eine die erzeugte Strahlung reflektierende Schicht besitzt.

25. Strahlungemittierendes Halbleiterbauelement nach einem der Ansprüche 1 bis 24,
**dadurch gekennzeichnet, dass** mindestens eine der Stromaufweitungsschichten (3,10) eine Ausnehmung (15) aufweist.

26. Strahlungemittierendes Halbleiterbauelement nach Anspruch 25,
**dadurch gekennzeichnet, dass**
in der Ausnehmung (15) eine elektrisch leitende Kontaktfläche (13) angeordnet ist.

27. Strahlungemittierendes Halbleiterbauelement nach Anspruch 26,
**dadurch gekennzeichnet, dass**
die elektrische Kontaktierung des strahlungemittierenden Halbleiterbauelements über die Kontaktfläche (13) erfolgt.

28. Strahlungemittierendes Halbleiterbauelement nach Anspruch 27,
**dadurch gekennzeichnet, dass**
an der der Halbleiterschichtenfolge (4) zugewandten Seite der Stromaufweitungsschicht (10) mit der Ausnehmung (15) und der Kontaktfläche (13) eine Mantelschicht oder eine Mantelschichtenfolge (14) sitzt.

29. Strahlungemittierendes Halbleiterbauelement nach Anspruch 28,
**dadurch gekennzeichnet, dass**
die Mantelschicht oder die Mantelschichtenfolge (14) bezüglich der Kontaktfläche (13) derart schlecht elektrisch leitend ist, dass der Strom teilweise in die Stromaufweitungsschicht (10) gelangt.

30. Strahlungemittierendes Halbleiterbauelement nach einem der Ansprüche 1 bis 29,
**dadurch gekennzeichnet, dass**
die Halbleiterschichtenfolge (4) einen III-V-Halbleiter enthält.

31. Strahlungemittierendes Halbleiterbauelement nach Anspruch 30,
**dadurch gekennzeichnet, dass**
die Halbleiterschichtenfolge (4) InₓGa_{y}Al_{1-x-y}P, mit 0≤x≤1, 0≤y≤1 und x+y≤1, InₓGa_{y}Al_{1-x-y}N, mit 0≤x≤1, 0≤y≤1 und x+y≤1, oder InₓGa_{y}Al_{1-x-y}As, mit 0≤x≤1, 0≤y≤1 und x+y≤1, enthält.

32. Strahlungemittierendes Halbleiterbauelement nach einem der Ansprüche 1 bis 31,
**dadurch gekennzeichnet, dass**
die erste Stromaufweitungsschicht ZnO enthält und seitens des Halbleiterkörpers an eine p-leitende AlGaAs-haltige Schicht grenzt.

33. Verfahren zur Herstellung eines strahlungemittierenden Halbleiterbauelements mit einem Halbleiterkörper, umfassend eine erste Hauptfläche (5), eine zweite Hauptfläche (9) und eine Halbleiterschichtenfolge (4) mit einer elektromagnetisehe Strahlung erzeugenden aktiven Zone (7), wobei die Halbleiterschichtenfolge (4) den Halbleiterkörper bildet und zwischen der ersten und der zweiten Hauptfläche (5,9) angeordnet ist,
**gekennzeichnet durch** die Schritte,
- Aufwachsen der Halbleiterschichtenfolge (4) auf einem Substrat (16) in einer Epitaxiephase;
- Aufbringen einer strahlungsdurchlässigen Stromaufweitungsschicht (3) auf die erste Hauptfläche (5) nach der Epitaxiephase;
- Ablösen des Substrats (16);
- Aufbringen einer strahlungsdurchlässigen Stromaufweitungsschicht (10) auf die zweite Hauptfläche (9) nach dem Ablösen des Substrats (16);
- Aufbringen einer Spiegelschicht auf die Stromaufweitungsschicht auf der ersten Hauptfläche (5);
- Befestigen des Halbleiterkörpers auf der Seite mit der Spiegelschicht (2) auf einem Träger (1).

34. Verfahren zur Herstellung eines strahlungemittierenden Halbleiterbauelements nach Anspruch 33,
**dadurch gekennzeichnet, dass**
die Stromaufweitungsschichten (3,10) durch Sputtern aufgebracht werden.

35. Verfahren zur Herstellung eines strahlungemittierenden Halbleiterbauelements nach Anspruch 33 oder 34,
**dadurch gekennzeichnet, dass**
die Spiegelschicht (2) durch Sputtern oder Aufdampfen aufgebracht wird.

36. Verfahren zur Herstellung eines strahlungemittierenden Halbleiterbauelements nach einem der Ansprüche 33 bis 35,
**dadurch gekennzeichnet, dass**
vor dem Aufbringen der Stromaufweitungsschichten (3,10) eine Mikrostruktur (12) in oder auf mindestens eine der Hauptflächen (5,9) auf- oder eingebracht wird.

37. Verfahren zur Herstellung eines strahlungemittierenden Halbleiterbauelements nach einem der Ansprüche 33 bis 36,
**dadurch gekennzeichnet, dass**
zwischen mindestens einer Stromaufweitungsschicht (3,10) und der nächstliegenden Hauptfläche (5,9) eine Mantelschichtenfolge (14) aufgebracht ist und dass diese eine Ausnehmung (15) aufweist, in die die elektrische Kontaktfläche (13) eingebracht wird.

## Claims

1. A radiation-emitting semiconductor component with a semiconductor body comprising a first main surface (5), a second main surface (9) and an epitaxially applied semiconductor layer sequence (4) with an electromagnetic radiation generating active zone (7), wherein
- the semiconductor layer sequence (4) forms the semiconductor body and is disposed between the first and the second main surfaces (5, 9),
- a first current spreading layer (3) is disposed outside the semiconductor body on the main surface (5) and is electrically conductively connected to the semiconductor layer sequence (4);
- a second current spreading layer (10) is disposed outside the semiconductor body on the second main surface (9) and is electrically conductively connected to the semiconductor layer sequence (4)
- the semiconductor layer sequence is connected via the first main surface with a carrier (1),
- the first current spreading layer is disposed between the carrier and the first main area, and a mirror layer (2) is disposed on the side of the first current spreading layer, which is remote from the semiconductor layer sequence;
- the first current spreading layer and the second current spreading layer contain an oxide, which is transparent to the generated radiation;
- the first current spreading layer (3) and the second current spreading layer (10) are different from each other with respect to the material; and
- the mirror layer contains a metal.

2. Radiation-emitting semiconductor component according to claim 1,
**characterized in that**
at least one of the two principal surfaces (5, 9) comprising the current spreading layers (3, 10) has a microstructure (12) .

3. Radiation-emitting semiconductor component according to claim 1 or 2,
**characterized in that**
the radiation-transparent material comprises ITO and/or InO.

4. Radiation-emitting semiconductor component according to claim 1 or 2,
**characterized in that**
the radiation-transparent material comprises ZnO.

5. Radiation-emitting semiconductor component according to claim 1 or 2,
**characterized in that**
the radiation-transparent material comprises SnO.

6. Radiation-emitting semiconductor component according to one of the claims 1 to 5,
**characterized in that**
at least one of the current spreading layers (3, 10) comprises Al, Ga, In, Ce, Sb and/or F.

7. Radiation-emitting semiconductor component according to one of the claims 1 to 6,
**characterized in that**
the mirror layer (2) is electrically conductive.

8. Radiation-emitting semiconductor component according to one of the claims 1 to 7,
**characterized in that**
the mirror layer (2) comprises Au, Ag, Al and/or Pt.

9. Radiation-emitting semiconductor component according to one of the claims 1 to 8,
**characterized in that**
the main surface (9) has a microstructure (12) on the side of the semiconductor layer sequence (4) facing away from the mirror layer (2).

10. Radiation-emitting semiconductor component according to one of the claims 1 to 9,
**characterized in that**
the semiconductor layer sequence (4) contains at least one n- and/or p-conductive layer (6, 8).

11. Radiation-emitting semiconductor component according to one of the claims 1 to 10,
**characterized in that**
the thickness of the n-conductive and/or the p-conductive layer (6, 8) is in the range of a monolayer to 1000 nm.

12. Radiation-emitting semiconductor component according to claim 11,
the thickness of the n-conductive and/or the p-conductive layer (6, 8) is smaller than 400 nm.

13. Radiation-emitting semiconductor component according to claim 11,
the thickness of the n-conductive and/or the p-conductive layer (6, 8) is between 150 nm and 350 nm.

14. Radiation-emitting semiconductor component according to claim 10 or 11,
**characterized in that**
the semiconductor layer sequence comprises at least one p-conductive layer and
the current spreading layer on the side comprising the p-conductive layer of the semiconductor layer sequence comprises ZnO.

15. Radiation-emitting semiconductor component according to claim 14,
**characterized in that**
the current spreading layer on the side comprising the p-conductive layer of the semiconductor layer sequence comprises ZnO and Al.

16. Radiation-emitting semiconductor component according to one of the claims 10 to 15,
**characterized in that**
the semiconductor layer sequence comprises at least one n-conductive layer and
the current spreading layer on the side comprising the n-conductive layer of the semiconductor layer sequence comprises SnO.

17. Radiation-emitting semiconductor component according to claim 16,
**characterized in that**
the current spreading layer on the side comprising the n-conductive layer of the semiconductor layer sequence contains SnO and Sb.

18. Radiation-emitting semiconductor component according to one of the claims 1 to 17,
**characterized in that**
the carrier (1) contains GaAs.

19. Radiation-emitting semiconductor component according to one of the claims 1 to 18,
**characterized in that**
the radiation-emitting semiconductor component is affixed to the carrier by means of a solder metallization (11).

20. Radiation-emitting semiconductor component according to claim 19,
the solder metallization (11) adjoins the carrier (2).

21. Radiation-emitting semiconductor component according to claim 20,
**characterized in that**
the solder metallization (11) is disposed on the mirror layer (2).

22. Radiation-emitting semiconductor component according to one of the claims 1 to 21,
**characterized in that**
a contact surface (13) for electrical contacting is disposed on a current spreading layer (10).

23. Radiation-emitting semiconductor component according to claim 22,
**characterized in that**
the contact surface (13) is disposed on the side of the semiconductor layer sequence (4) opposite to the carrier (1).

24. Radiation-emitting semiconductor component according to claim 22 or 23,
**characterized in that**
the contact surface (13) on the side facing the semiconductor layer sequence (4) has a layer that reflects the generated radiation.

25. Radiation-emitting semiconductor component according to one of the claims 1 to 24,
**characterized in that**
at least one of the current spreading layers (3, 10) comprises a recess (15).

26. Radiation-emitting semiconductor component according to claim 25,
**characterized in that**
an electrically conductive contact surface (13) is disposed in the recess (15).

27. Radiation-emitting semiconductor component according to claim 26,
**characterized in that**
the electrical contacting of the radiation-emitting semiconductor component takes place via the contact surface (13).

28. Radiation-emitting semiconductor component according to claim 27,
**characterized in that**
a cladding layer or a cladding layer sequence (14) is disposed on the side of the current spreading layer (10), which is provided with the recess (15), facing the semiconductor layer sequence (4) and the contact surface (13).

29. Radiation-emitting semiconductor component according to claim 28,
**characterized in that**
the cladding layer or a cladding layer sequence (14) is poorly electrically conductive with respect to the contact surface (13), such that the current partially flows into the current spreading layer (10).

30. Radiation-emitting semiconductor component according to one of the claims 1 to 29,
**characterized in that**
the semiconductor layer sequence (4) comprises a III/V semiconductor.

31. Radiation-emitting semiconductor component according to claim 30,
**characterized in that**
the semiconductor layer sequence (4) comprises InₓGa_{y}Al_{1-x-y}P, where 0 ≤ x ≤ 1, 0 ≤ y ≤ 1 and x + y ≤ 1, InₓGa_{y}Al_{1-x-y}N, where 0 ≤ x ≤ 1, 0 ≤ y ≤ 1 and x + y ≤ 1, or InₓGa_{y}Al_{1-x-y}As, where 0 ≤ x ≤ 1, 0 ≤ y ≤ 1 and x + y ≤ 1.

32. Radiation-emitting semiconductor component according to one of the claims 1 to 31,
**characterized in that**
the first current spreading layer comprises ZnO and adjoins a p-conductive AlGaAs-containing layer on the side of the semiconductor body.

33. Method for producing a radiation-emitting semiconductor component with a semiconductor body comprising a first main surface (5), a second main surface (9) and a semiconductor layer sequence (4) with an electromagnetic radiation generating active zone (7), wherein the semiconductor layer sequence (4) forms the semiconductor body and is disposed between the first and the second main surfaces (5, 9), **characterized by** the steps of
- growth of the semiconductor layer sequence (4) on a substrate (16) in an epitaxial phase;
- applying a radiation-transparent current spreading layer (3) to the first main surface (5) after the epitaxial phase;
- removing the substrate (16);
- applying a radiation-transparent current spreading layer (10) to the second main surface (9) after removing the substrate (16);
- applying a mirror layer (2) to the current spreading layer on the first main surface (5);
- affixing the semiconductor body on the side with the mirror layer (2) to a carrier (1).

34. Method for producing a radiation-emitting semiconductor component according to claim 33,
**characterized in that**
the current spreading layers (3, 10) are applied by sputtering.

35. Method for producing a radiation-emitting semiconductor component according to claim 33 or 34,
**characterized in that**
the mirror layer (2) is applied by sputtering or vapor deposition.

36. Method for producing a radiation-emitting semiconductor component according to one of the claims 33 or 35, **characterized in that**
before the application of the current spreading layers (3, 10), a microstructure (12) is applied or built into or onto at least one of the main surfaces (5, 9).

37. Method for producing a radiation-emitting semiconductor component according to one of the claims 33 or 36, **characterized in that**
a cladding layer sequence (14) is applied between at least one current spreading layer (3, 10) and the adjacent main surface (5, 9) and comprises a recess (15) in which the electrical contact surface (13) is formed.

## Revendications

1. Dispositif à semi-conducteur émetteur de rayonnement avec un corps semi-conducteur, comportant une première surface principale (5), une deuxième surface principale (9) et une succession de couches semi-conductrices (4) formée par croissance épitaxiale comprenant une zone active (7) génératrice de rayonnement électromagnétique,
- la succession de couches semi-conductrices (4) constituant le corps semi-conducteur et étant disposée entre la première et la deuxième surface principale (5,9),
- une première couche d'élargissement de courant (3) étant disposée à l'extérieur du corps semi-conducteur sur la première surface principale (5) et reliée de manière électro-conductrice à la succession de couches semi-conductrices (4);
- une deuxième couche d'élargissement de courant (10) étant disposée à l'extérieur du corps semi-conducteur sur la deuxième surface principale (9) et reliée de manière électro-conductrice à la succession de couches semi-conductrices (4) ;
- la succession de couches semi-conductrices étant reliée à un support (1) par l'intermédiaire de la première surface principale ;
- la première couche d'élargissement de courant étant disposée entre le support et la première surface principale et une couche miroir (2) étant disposée sur le côté de la première couche d'élargissement de courant opposé à la suite des couches semi-conductrices ;
- la première couche et la deuxième couche d'élargissement de courant contenant un oxyde perméable au rayonnement généré ; la première couche d'élargissement de courant (3) et la deuxième couche d'élargissement de courant (10) étant différentes en ce qui concerne leurs matériaux ; et
- la couche miroir contenant un métal.

2. Dispositif à semi-conducteur émetteur de rayonnement selon la revendication 1,
**caractérisé en ce qu'**au moins une des surfaces principales (5, 9) comportant les couches d'élargissement de courant (3, 10) présente une microstructure (12).

3. Dispositif à semi-conducteur émetteur de rayonnement selon la revendication 1 ou 2,
**caractérisé en ce que** le matériau perméable au rayonnement contient de l'ITO ou de l'InO.

4. Dispositif à semi-conducteur émetteur de rayonnement selon la revendication 1 ou 2,
**caractérisé en ce que** le matériau perméable au rayonnement contient du ZnO.

5. Dispositif à semi-conducteur émetteur de rayonnement selon la revendication 1 ou 2,
**caractérisé en ce que** le matériau perméable au rayonnement contient du SnO.

6. Dispositif à semi-conducteur émetteur de rayonnement selon l'une quelconque des revendications 1 à 5,
**caractérisé en ce qu'**au moins une des couches d'élargissement de courant (3, 10) contient de l'Al, du Ga, de l'In, du Ce, du Sb et/ou du F.

7. Dispositif à semi-conducteur émetteur de rayonnement selon l'une quelconque des revendications 1 à 6,
**caractérisé en ce que** la couche miroir (2) est électro-conductrice.

8. Dispositif à semi-conducteur émetteur de rayonnement selon l'une quelconque des revendications 1 à 7,
**caractérisé en ce que** la couche miroir (2) contient de l'Au, de l'Ag, de l'Al et/ou du Pt.

9. Dispositif à semi-conducteur émetteur de rayonnement selon l'une quelconque des revendications 1 à 8,
**caractérisé en ce que** la surface principale (9) présente une microstructure (12) sur le côté de la succession de couches semi-conductrices (4) opposé à la couche miroir (2).

10. Dispositif à semi-conducteur émetteur de rayonnement selon l'une quelconque des revendications 1 à 9,
**caractérisé en ce que** la succession de couches semi-conductrices (4) contient au moins une couche conductrice n et/ou une couche conductrice p (6,8).

11. Dispositif à semi-conducteur émetteur de rayonnement selon la revendication 10,
**caractérisé en ce que** l'épaisseur des couches conductrices n et/ou des couches conductrices p (6,8) est de l'ordre d'une monocouche à 1000 nm.

12. Dispositif à semi-conducteur émetteur de rayonnement selon la revendication 11,
**caractérisé en ce que** l'épaisseur des couches conductrices n et/ou des couches conductrices p (6,8) est inférieure à 400 nm.

13. Dispositif à semi-conducteur émetteur de rayonnement selon la revendication 11,
**caractérisé en ce que** l'épaisseur des couches conductrices n et/ou des couches conductrices p (6,8) est entre 150 nm et 350 nm.

14. Dispositif à semi-conducteur émetteur de rayonnement selon la revendication 10 ou 11,
**caractérisé en ce que** la succession de couches semi-conductrices contient au moins une couche conductrice p, et la couche d'élargissement de courant contient du ZnO sur le côté de la couche conductrice p de la succession de couches semi-conductrices.

15. Dispositif à semi-conducteur émetteur de rayonnement selon la revendication 14,
**caractérisé en ce que** la couche d'élargissement de courant contient du ZnO et de l'Al sur le côté de la couche conductrice p de la succession de couches semi-conductrices.

16. Dispositif à semi-conducteur émetteur de rayonnement selon l'une quelconque des revendications 10 à 15,
**caractérisé en ce que** la succession de couches semi-conductrices contient au moins une couche conductrice n, et la couche d'élargissement de courant contient du SnO sur le côté de la couche conductrice p de la succession de couches semi-conductrices.

17. Dispositif à semi-conducteur émetteur de rayonnement selon la revendication 16,
**caractérisé en ce que** la couche d'élargissement de courant contient du SnO et du Sb sur le côté de la couche conductrice n de la succession de couches semi-conductrices.

18. Dispositif à semi-conducteur émetteur de rayonnement selon l'une quelconque des revendications 1 à 17, **caractérisé en ce que** le support (1) contient du GaAs.

19. Dispositif à semi-conducteur émetteur de rayonnement selon l'une quelconque des revendications 1 à 18,
**caractérisé en ce que** le dispositif à semi-conducteur émetteur de rayonnement est fixé sur le support par l'intermédiaire d'une métallisation brasée (11).

20. Dispositif à semi-conducteur émetteur de rayonnement selon la revendication 19,
**caractérisé en ce que** la métallisation brasée est directement adjacente au support (1).

21. Dispositif à semi-conducteur émetteur de rayonnement selon la revendication 20,
**caractérisé en ce que** la métallisation brasée (11) est disposée sur la couche miroir (2).

22. Dispositif à semi-conducteur émetteur de rayonnement selon l'une quelconque des revendications 1 à 21,
**caractérisé en ce qu'**une surface de contact (13) pour la mise en contact électrique est disposée sur une couche d'élargissement de courant (10).

23. Dispositif à semi-conducteur émetteur de rayonnement selon la revendication 22,
**caractérisé en ce que** la surface de contact (13) est disposée sur le côté de la succession de couches semi-conductrices (4) opposé au support (1).

24. Dispositif à semi-conducteur émetteur de rayonnement selon la revendication 22 ou 23,
**caractérisé en ce que** la surface de contact (13) possède une couche reflétant le rayonnement généré sur le côté faisant face à la succession de couches semi-conductrices (4).

25. Dispositif à semi-conducteur émetteur de rayonnement selon l'une quelconque des revendications 1 à 24,
**caractérisé en ce qu'**au moins une des couches d'élargissement de courant (3, 10) présente un creux (15).

26. Dispositif à semi-conducteur émetteur de rayonnement selon la revendication 25,
**caractérisé en ce qu'**une surface de contact électro-conductrice (13) est disposée dans le creux (15).

27. Dispositif à semi-conducteur émetteur de rayonnement selon la revendication 26,
**caractérisé en ce que** la mise en contact du composant semi-conducteur émetteur de rayonnement est effectuée par l'intermédiaire de la surface de contact (13).

28. Dispositif à semi-conducteur émetteur de rayonnement selon la revendication 27,
**caractérisé en ce qu'**une couche enveloppe ou une succession de couches enveloppe (14) est située sur le côté de l'élargissement de courant (10) faisant face à la succession de couches semi-conductrices (4) et comprenant le creux (15) et la surface de contact (13).

29. Dispositif à semi-conducteur émetteur de rayonnement selon la revendication 28,
**caractérisé en ce que** la capacité électro-conductrice de la couche enveloppe ou de la succession de couches enveloppe (14) par rapport à la surface de contact (13) est tellement faible que le courant partiellement atteint la couche de l'élargissement de courant (10).

30. Dispositif à semi-conducteur émetteur de rayonnement selon l'une quelconque des revendications 1 à 29,
**caractérisé en ce que** la succession de couches semi-conductrices (4) contient un semi-conducteur III-V.

31. Dispositif à semi-conducteur émetteur de rayonnement selon la revendication 30,
**caractérisé en ce que** la couche semi-conductrice (4) contient de l'InxGayAl1-x-yP avec 0≤x≤1, 0≤y≤1 et x+y≤1, de l'InxGayAl1-x-yN avec 0≤x≤1, 0≤y≤1 et x+y≤1 ou de l'InxGayAl1-x-yAs avec 0≤x≤1, 0≤y≤1 et x+y≤1.

32. Dispositif à semi-conducteur émetteur de rayonnement selon l'une quelconque des revendications 1 à 31,
**caractérisé en ce que** la première couche de l'élargissement de courant contient du ZnO et, du côté du corps semi-conducteur, est adjacente à une couche conductrice p contenant de l'AlGaAs.

33. Procédé pour l'obtention d'un composant semi-conducteur émetteur de rayonnement avec un corps semi-conducteur, comportant une première surface principale (5), une deuxième surface principale (9) et une succession de couches semi-conductrices (4) avec une zone active (7) génératrice de rayonnement électromagnétique, la succession de couches semi-conductrices (4) formant le corps semi-conducteur et étant disposée entre la première et la deuxième surface principale (5, 9),
**caractérisé par** les étapes suivantes :
- faire croître une succession de couches semi-conductrices (4) sur un substrat (16) dans une phase d'épitaxie;
déposer une couche d'élargissement de courant (3) sur la première surface principale (5) après la phase d'épitaxie;
- décoller le substrat (16);
- déposer une couche d'élargissement de courant perméable au rayonnement (10) sur la deuxième surface principale (9) après
- le décollage du substrat (16);
- déposer une couche miroir sur la couche d'élargissement de courant disposée sur la première surface principale (5);
- fixer le corps semi-conducteur sur le côté comprenant la couche miroir (2) à un support (1).

34. Procédé pour l'obtention d'un composant semi-conducteur émetteur de rayonnement selon la revendication 33; **caractérisé en ce que** les couches d'élargissement de courant (3, 10) sont appliquées par pulvérisation cathodique.

35. Procédé pour l'obtention d'un composant semi-conducteur émetteur de rayonnement selon la revendication 33 ou 34, **caractérisé en ce que** la couche miroir (2) est appliquée par pulvérisation cathodique ou vaporisation.

36. Procédé pour l'obtention d'un composant semi-conducteur émetteur de rayonnement selon l'une quelconque des revendications 33 à 35,
**caractérisé en ce qu'**une microstructure (12) est appliquée sur ou insérée dans au moins une des surfaces principales (5,9) avant l'application des couches d'élargissement de courant (3,10).

37. Procédé pour l'obtention d'un composant semi-conducteur émetteur de rayonnement selon l'une quelconque des revendications 33 à 36,
**caractérisé en ce qu'**une succession de couches enveloppe (14) est appliquée entre au moins une couche d'élargissement de courant (3, 10) et la surface principale la plus proche (5,9) et que la succession de couches enveloppe présente un creux (15) dans lequel la surface de contact électrique (13) est insérée.
